# EUROPEAN PATENT APPLICATION

(11) **EP 1 767 602 A2**
(43) Date of publication of application: **28.03.2007**
(21) Application number: 06019195.4
(22) Date of filing: 13.09.2006
(51) Int. Cl.: C09G 1/02

(54) **Metal-polishing liquid and chemical-mechanical polishing method**

(30) Priority: 22.09.2005 JP 2005276827
(71) Applicant: FUJIFILM Corporation, Minato-ku Tokyo (JP)
(72) Inventor: Sugiyama, Shinichi, Yoshida-cho, Haibara-gun, Shizuoka-ken (JP)
(74) Representative: HOFFMANN EITLE

(57) **Abstract**

The present invention provides a metal-polishing liquid comprising an oxidizing agent and a heterocyclic aromatic ring compound, wherein the time until the oxidation reaction rate is (E1+E2)/2 is shorter than 1.0 second, E1 being an oxidation reaction rate immediately after initiation of oxidation of a metal surface to be polished and E2 being an oxidation reaction rate when the oxidation reaction has reached a steady state.

## Description

### BACKGROUND OF THE INVENTION

### Field of the invention

The present invention relates to manufacturing of a semiconductor device and, particularly, it relates to a metal-polishing liquid in a wiring process of a semiconductor device, and a chemical-mechanical polishing method using the same.

### Description of the Related Art

In development of a semiconductor device, a representative of which is a semiconductor integrated circuit (hereinafter, referred to as LSI), a higher density and higher integration by miniaturization and lamination of a wiring are required for higher integration and a higher speed. As the technique therefor, various techniques such as Chemical -Mechanical Polishing (hereinafter, referred to as CMP) have been used.

A general method of CMP is to apply a polishing pad on a circular polishing platen, impregnate a polishing pad surface with a polishing liquid, push a surface of a substrate (wafer) against a pad and, in the state where a predetermined pressure (polishing pressure) is applied from a back, rotate both of a polishing platen and a substrate, and flatten a surface of a substrate by a generated mechanical friction.

A metal-polishing liquid used in CMP generally contains abrasives (e.g. alumina, silica) and an oxidizing agent (e.g. hydrogen peroxide, persulfuric acid), and it is thought that a substrate surface is polished by oxidizing a metal surface with an oxidizing agent and removing the oxidized film with abrasives.

However, when CMP is performed using such the metal-polishing liquid containing solid abrasives, a polishing flaw (scratch), phenomenon in which a whole polishing surface is polished more than necessary (thinning), phenomenon in which a polishing metal surface is not planar, only a central part is polished deeper, and a dish-like recess is produced (dishing), and phenomenon in which an insulating material between metal wirings is polished more than necessary, and a plurality of wiring metal surfaces form a dish-like concave part (erosion) occur in some cases.

In order to solve such the problem in the previous solid abrasives, a metal-polishing liquid which does not contain abrasives, and consists of hydrogen peroxide/malic acid/benzotriazole/ammonium polyacrylate is disclosed (for example, see Japanese Patent Application Laid-Open (JP-A) No. 2001-127019). According to this method, a metal film at a convex part of a semiconductor substrate is selectively chemically and mechanically polished, a metal film is left at a concave part, and a desired conductive body pattern is obtained, but since CMP progresses by friction with a polishing pad which is far softer mechanically than that containing the previous solid abrasives, there is a problem that it is difficult to obtain a sufficient polishing rate.

On the other hand, aiming at further higher performance, LSI using copper having a low wiring resistance as a metal for wiring has been developed. With miniaturization of a wiring aiming at a higher density, it becomes necessary to improve electrical conductivity of a copper wiring and electron migration resistance and, accompanying this, use of a copper alloy in which a minor amount of a third component such as silver is added to highly pure copper has been initiated to be studied. At the same time, a high speed metal polishing means which can exert high productivity without contaminating these high precision and high pure materials is demanded.

In addition, recently, in order to improve productivity, a wafer diameter at manufacturing of LSI has been increased and, currently, a diameter of 200 mm or more is generally used, and manufacturing at a size of 300 mm or more has been initiated. Accompanying such the increase in a size, a difference in a polishing rate between a central part and a peripheral part of a wafer becomes large, and improvement in in-plane uniformity has been strongly demanded.

As a chemical polishing method without a means for mechanically polishing copper and a copper alloy, a chemical polishing method based on only dissolving action is also known (for example, see JP-A No. 49-122432). However, as compared with CMP in which a metal film at a convex part is selectively polished chemically and mechanically, a problem of occurrence of dishing easily arises, and maintenance of planarity becomes a goal.

To the contrary, a method of lowering a temperature of a system at polishing to suppress dishing is described (for example, see JP-A No. 8-83780), but this is the technique having the high process cost and lacking general utility.

### SUMMARY OF THE INVENTION

The present invention has been made in view of the above circumstances and provides metal polishing liquid and chemical-mechanical polishing method.

A first aspect of the invention provides a metal-polishing liquid comprising an oxidizing agent and a heterocyclic aromatic ring compound, wherein the time until the oxidation reaction rate is (E1+E2)/2 is shorter than 1.0 second, E1 being an oxidation reaction rate immediately after initiation of oxidation of a metal surface to be polished and E2 being an oxidation reaction rate when the oxidation reaction has reached a steady state.

### DETAILED DESCRIPTION OF THE INVENTION

The metal-polishing liquid and chemical mechanical-polishing method of the present invention will be described below in detail.

The present inventors found out that polishing of copper progresses by etching, that is, oxidation of metal copper and subsequent dissolution, is not simply oxidation-reactive, and both of better in-plane uniformity and low scratch can be realized by controlling a temporal behavior of an oxidation reaction, by an oxidation reaction rate E1 described later immediately after initiation of oxidation of a subject metal surface, and an oxidation reaction rate E2 described later when an oxidation reaction has approached the steady state. An innovative point of the invention is that balance between a passive film forming rate and a passive film removing rate is adjusted, the state of a passive film during polishing is retained so as to be uniformly generated, and both of improvement in in-plane uniformity, and low scratch have been realized.

### <E1 and E2 measuring method>

A reaction of oxidizing a metal surface can be evaluated by measuring an electrochemical erosion current and, in the invention, an oxidation reaction rate E 1 immediately after initiation of oxidation of a metal surface to be polished, and an oxidation reaction rate E2 when an oxidation reaction has reached the stead state can be obtained by an electrochemical analyzing procedure. A measurement temperature is a temperature at actual polishing and, since a temperature is generally 30 to 50°C during polishing, measurement can be performed conveniently at 40°C.

Specifically, a metal-polishing liquid containing no oxidizing agent is used as an electrolyte, and a metal to be polished is used as a working electrode. As a counter electrode, a platinum electrode is used. It is preferable to use a silver-silver chloride electrode as a reference electrode, and other reference electrode such as a saturated calomel electrode may be used. A corrosion potential when an oxidizing agent is contained, and a corrosion potential when an oxidizing agent is not contained are measured, and a difference in those potentials is adopted as an oxidation potential based on an oxidizing agent. A metal-polishing liquid containing no oxidizing agent is used as an electrolyte, and the open circuit state is retained. Thereafter, a voltage corresponding to an oxidation potential based on an oxidizing agent is applied, and a corrosion current value and its temporal change are measured at a subsecond level. An oxidation reaction rate (nm/min) can be obtained from a corrosion current density (A/cm²) and a density of a metal to be polished (g/cm³).

Assuming that 100 milliseconds after voltage application is immediately after initiation of oxidation of a metal surface, and after 100 seconds after voltage application is in the steady state, an oxidation reaction rate E1 immediately after initiation of oxidation of a metal surface to be polished, and an oxidation reaction rate E2 when an oxidation reaction has reached the steady state are obtained.

The time until the oxidation reaction rate is (E1+E2)/2 is shorter than 1.0 second, preferably 0.8 second or shorter, further preferably 0.5 second or shorter, particularly preferably 0.2 second or shorter. When the time exceeds 1.0 second, since oxidation of metal oxide progresses mildly, deterioration in in-plane uniformity due to progression of local polishing, and increase in a scratch amount occur.

In the invention, E1/E2 is 1.5 or more, preferably 2 or more, further preferably 4 or more, most preferably 8 or more. There is not particularly an upper limit. E2 is preferably 1.0 nm/min or less, more preferably 0.5 nm/min or less, further preferably 0.2 nm/min or less. E2 is preferably 0.01 nm/min or more.

A method of preparing a metal-polishing liquid in which the time until the oxidation reaction rate is (E1+E2)/2 is less than 1.0 second and, further, E2 is 1.0 nm/min or less will be described later, and the liquid can be prepared by adding a heterocyclic aromatic ring compound. That is, for example, when a preferable heterocyclic aromatic ring compound described later is added to a metal-polishing liquid at an appropriate amount, the time until the aforementioned oxidation reaction rate is (E1+E2)/2 becomes less than 1.0 second and, when the compound is not added, the time becomes 1.0 second or more.

It is preferable that a heterocyclic aromatic ring compound has greater adsorbability onto a metal to be polished than adsorbability onto oxide of a metal to be polished.

For example, in the case where a metal to be polished is copper, a heterocyclic aromatic ring compound is adsorbed onto metal copper or oxide copper to form a passive film, thereby, suppressing an oxidation reaction. On the other hand, in the case where the compound is more easily adsorbed onto metal copper than oxide copper, an oxidation reaction is suppressed before progression of an oxidation reaction. On the other hand, in the case where the compound is more easily adsorbed onto copper oxide than metal oxide, since suppression of an oxidation reaction is weak at an initial stage of an oxidation reaction, and the compound is adsorbed onto an oxidized copper ion with progression of an oxidation reaction, oxidation reaction suppression functions with progression of an oxidation reaction.

Adsorbability onto metal copper or copper oxide can be measured by the following method. A metal copper particle or a copper oxide particle having a dilute sulfuric acid-treated surface, on which a specific surface area is known, is dispersed in water, a heterocyclic aromatic ring compound having a predetermined concentration is added, and an adsorption amount is measured. At this time, a surface area of a metal copper particle and that of a copper oxide particle are made to be equal. For measuring an adsorption amount, there are a method of quantitating a concentration of an unadsorbed heterocyclic aromatic ring compound from a supernatant, and subtracting this from an addition amount, and a method of dissolving a metal copper particle or a copper oxide particle in dilute sulfuric acid, and obtaining an adsorption amount from a concentration of a heterocyclic aromatic ring in the solution. Selectivity of adsorption onto metal copper and copper oxide can be expressed by a ratio of respective adsorption amounts. In the invention, it is preferable that a heterocyclic aromatic ring compound is more easily adsorbed onto copper oxide than metal oxide, that is, adsorption selectivity of "copper oxide/metal copper" is less than 1, further preferably less than 0.5.

In order to enhance adsorption selectivity of copper oxide/metal copper, LogP of a heterocyclic aromatic ring compound is preferably greater than 1.0, further preferably 1.5 to 5.0.

A logP value means a common logarithm of a partition coefficient P, is a physical property value expressing how an organic compound is partitioned in equilibrium of a 2 phase system of an oil and water, by a quantitative numerical value, and means that when the value becomes greater on a plus side relative to 0, oil-solubility is increased and, when an absolute value of the value becomes greater on a minus side, water-solubility is increased.

In the invention, as a logP value, a value obtained by calculation which will be explained below is used. That is, the logP value is a value obtained by a program presumably calculating a logP(=log(Coil/Cwater); Coil=mol concentration in oily phase, Cwater=mole concentration in aqueous phase) value developed by a Medchem project of C. Hansch, A. Leo et al. of Pomona University, USP. This program is based on a Hansch-Leo fragment method, presumably calculates a logP value by dividing a chemical structure into partial structures (fragments), and summing a contribution fraction of a common logarithm (logP) of a partition coefficient given by the fragment, and details are described in the literature such as C. Hansch & A. Leo, Substituent Constants For Correlation Analysis in Chemistry and Biology, and A. J. Leo Calculating logPoct from structure (Chem. Rev., 93, 1581-1306, 1993).

It is preferable that a heterocyclic aromatic ring compound is deprotonated and is negatively ionized in a polishing liquid, and it is preferable that a pKa is smaller than a pH of a polishing liquid by 2 or more.

In the invention, in order to uniformly polish in a wafer plane, it is effective to control a passive film forming rate and, at the same time, control a passive film removing rate. When the time until the oxidation reaction rate is (E1+E2)/2 is within a range of the invention, an abrasive concentration is preferably 2 % by mass or less, further preferably 1 % by mass or less, most preferably 0.5 % by mass or less. Alternatively, it is also preferable that an abrasive is not substantially contained.

A composition of a metal-polishing liquid will be explained below, but is not limited to this. In the invention, the "metal-polishing liquid" means to include not only a polishing liquid upon use for polishing (i.e. polishing liquid which has been diluted as necessary), but also a concentrate of a metal-polishing liquid. A concentrate or a concentrated polishing liquid means a polishing liquid in which a concentration of a solute is adjusted higher than that of a polishing liquid upon use in polishing, and this is used in polishing by diluting with water or an aqueous solution upon use in polishing. A diluting rate is generally 1 to 20-fold by volume. In the present specification, the "concentration" and the "concentrate" are used according to a conventional expression which means "concentrated" and "more concentrated liquid" than the use state, and is used in a different usage from a meaning of a general term accompanying physical concentration procedure such as distillation.

### [Heterocyclic aromatic ring compound]

It is preferable that a metal-polishing liquid contains a heterocyclic aromatic ring compound. A heterocyclic aromatic ring compound is a compound having an aromatic ring such as a benzene ring and a naphthalene ring and having a molecular weight of preferably 20 to 600.

In the invention, it is preferable that, as a heterocyclic aromatic ring compound, particularly, at least one kind compound selected from benzotriazoles and derivatives thereof is contained.

As benzotriazoles and derivatives thereof, a compound represented by the formula (A) is preferable.

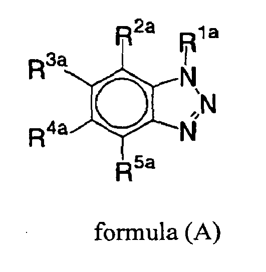

In the formula (A), R^{1a} to R^{5a} each independently represent a substituent, provided that R^{2a} to R^{5a} are a substituent other than a methyl group, and adjacent two among R^{1a} to R^{5a} may be taken together to form a ring.

A substituent as R^{1a} to R^{5a} in the formula (A) is not particularly limited, but examples include as follows:
a halogen atom (fluorine atom, chlorine atom, bromine atom or iodine atom), an alkyl group (straight, branched or cyclic alkyl group; the alkyl group may be polycyclic alkyl group such as bicycloalkyl group, or may contain active methine group), an alkenyl group, an alkynyl group, an aryl group, a heterocyclic group (any substitution position is possible), an acyl group, an alkoxycarbonyl group, an aryloxycarbonyl group, a hetercyclic oxycarbonyl group, a carbamoyl group (examples of carbamoyl group having substituent include N-hydroxycarbamoyl group, N-acylcarbamoyl group, N-sulfonylcarbamoyl group, N-carbamoylcarbamoyl group, thiocarbamoyl group, N-sulfamoylcarbamoyl group), a carbazoyl group, a carboxy group or a salt thereof, an oxalyl group, an oxamoyl group, a cyano group, a carbonimidoyl group, a formyl group, a hydroxy group, an alkoxy group (including a group containing ethyleneoxy group or propyleneoxy group unit repeatedly), an aryloxy group, a heterocyclic oxy group, an acyloxy group, an (alkoxy or aryloxy)carbonyloxy group, a carbamoyloxy group, a sulfonyloxy group;
an amino group, an (alkyl, aryl or heterocyclic)amino group, an acylamino group, a sulfonamido group, an ureido group, a thioureido group, a N-hydroxyureido group, an imido group, an (alkoxy or aryloxy)carbonylamino group, a sulfamoylamino group, a semicarbazido group, a thiosemicarbazido group, a hydrazino group, an ammonio group, an oxamoylamino group, a N-(alkyl or aryl)sulfonylureido group, a N-acylureido group, a N-acylsulfamoylamino group, a hydroxyamino group, a nitro group, a heterocyclic group containing a quaternized nitrogen atom (e.g. pyridinio group, imidazolio group, quinolinio group, isoquinolinio group), an isocyano group, an imino group, a mercapto group, an (alkyl, aryl or heterocyclic)thio group, an (alkyl, aryl or heterocyclic)dithio group, an (alkyl or aryl)sulfonyl group, an (alkyl or aryl)sulfinyl group, a sulfo group or a salt thereof, a sulfamoyl group (examples of sulfamoyl group having substituent include N-acylsulfamoyl group, N-sulfonylsulfamoyl group) or a salt thereof, a phosphino group, a phosphinyl group, a phosphinyloxy group, a phosphinylamino group, and a silyl group.

An active methine group means a methine group substituted with two electron withdrawing groups, and an electron withdrawing group means, for example, an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group, and a carbonimidoyl group. Two electron withdrawing groups may be taken together to take a cyclic structure. A salt means a cation such as an alkali metal, an alkaline earth metal, and a heavy metal, and an organic cation such as an ammonium ion, and a phospholium ion.

These substituents may be further substituted with these substituents. Among them, a preferable substituent is such that at least one of R^{2a} to R^{5a} is a substituent other than an alkyl group having no substituent, further preferably such that R^{2a} to R^{5a} are other than a hydrogen atom and a methyl group.

A molecular weight of a compound represented by the formula (A) is preferably 20 to 600, more preferably 40 to 400.

A compound represented by the formula (A) may be used alone, or two or more kinds may be used together. A compound represented by the general formula (A) may be a commercially available product, or may be synthesized according to a conventional method.

An amount of the compound having an aromatic ring to be added is, as a total amount, preferably 0.0001 to 1.0 mol, more preferably 0.001 to 0.5 mol, further preferably 0.01 to 0.1 mol in 1 L of a metal-polishing liquid (i.e. polishing liquid after dilution when the liquid is diluted with water or aqueous solution; hereinafter, "polishing liquid upon use in polishing" has the same meaning) upon use in polishing. That is, an amount of the compound having an aromatic ring to be added is preferably 1.0 mol or less in 1 L of a polishing liquid upon use in polishing from a viewpoint of prevention of deterioration (effectless, degradation) of an oxidizing agent and these compounds, and preferably 0.0001 mol or more from a viewpoint of sufficient effect.

In addition, thiocyanates, thioethers, thiosulfate salt or mesoionic compound may be used together at a smaller addition amount than that of tetrazoles and derivative thereof or anthranilic acids and derivatives thereof.

The metal-polishing liquid of the invention contains at least an oxidizing agent as a constitutional component, and is usually an aqueous solution. The metal-polishing liquid of the invention may further contain other component, and examples of a preferable component include abrasives, a compound which is added as a so-called film forming agent, a surfactant, a water-soluble polymer, and an additive. One kind or two or more kinds of each component contained in a liquid-polishing liquid may be used together. Alternatively, an oxidizing agent may be added to a composition containing other components immediately before use, to form a polishing liquid.

### (Oxidizing agent)

The metal-polishing liquid of the invention contains a compound which can oxidize a metal to be polished (oxidizing agent). Specifically, examples include hydrogen peroxide, peroxide, nitrate, iodate, periodate, hypochlorite, chlorite, chlorate, perchlorate, persulfate, bichromate, permanganate, ozone water, silver (II) salt, and iron (III) salt, and hydrogen peroxide is more preferably used.

An amount of an oxidizing agent to be added is preferably 0.003 mol to 8 mol, more preferably 0.03 mol to 6 mol, particularly preferably 0.1 mol to 4 mol in 1 L of a metal-polishing liquid upon use in polishing. That is, an amount of an oxidizing agent to be added is preferably 0.003 mol or more from a viewpoint that oxidation of a metal is sufficient, and a high CMP rate is maintained, and preferably 8 mol or less from a viewpoint of prevention of roughening of a polishing surface.

### (Organic acid)

It is preferable that the metal-polishing liquid of the invention contains an organic acid apart from the oxidizing agent. An organic acid referred herein is a compound having a different structure from that of an oxidizing agent for oxidizing a metal, and does not include an acid which functions as the aforementioned oxidizing agent.

As an organic acid, a water-soluble organic acid is desirable and, specifically, for example, amino acids such as glycine, L-alanine, β-alanine, L-2-aminobutyric acid, L-norvaline, L-valine, L-leucine, L-norleucine, L-isoleucine, L-alloisoleucine, L-phenylalanine, L-proline, sarcosine, L-ornithine, L-lysine, taurine, L-serine, L-threonine, L-allothreonine, L-homoserine, L-tyrosine, 3,5-diiodo-L-tyrosine, β-(3,4-dihydroxyphenyl)-L-alanine, L-thyroxine, 4-hydroxy-L-proline, L-cysteine, L-methionine, L-ethionine, L-lanthionine, L-cystathinine, L-cystine, L-cysteic acid, L-aspartic acid, L-glutamic acid, S-(carboxymethyl)-L-cysteine, 4-aminobutyric acid, L-asparagine, L-glutamine, azaserine, L-alginine, L-canavanine, L-citrulline, δ-hydroxy-L-lysine, creatine, L-kynurenine, L-histidine, 1-methyl-L-histidine, 3-methyl-L-histidine, ergothioneine, L-tryptophan, actinomycin C1, apamine, angioteisin I, angioteisin II and antipine are preferable.

In addition, as other amino acid, particularly, in the invention, an organic acid containing a secondary or tertiary nitrogen atom is preferable. Examples of an organic acid containing a secondary or tertiary nitrogen atom include the following compounds [exemplified compounds (I-1) to (I-21)]. However, a preferable organic acid in the invention is not limited to these exemplified compounds.

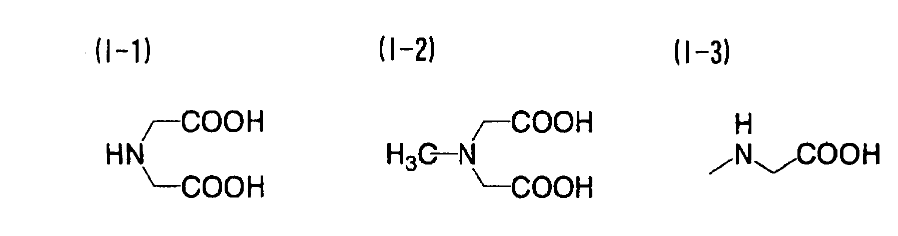

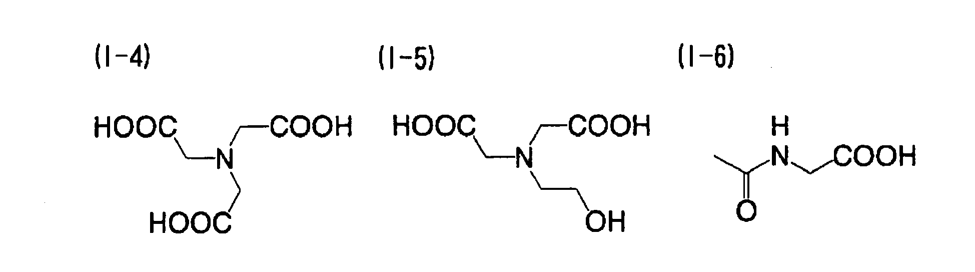

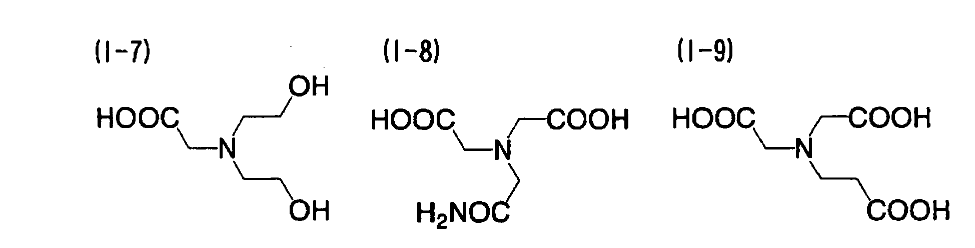

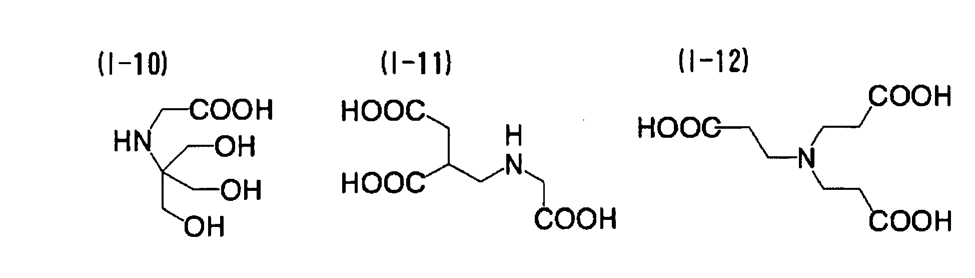

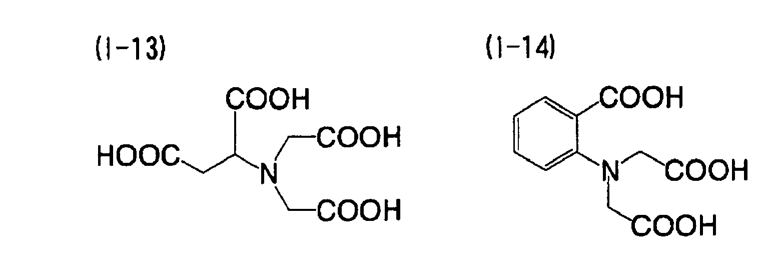

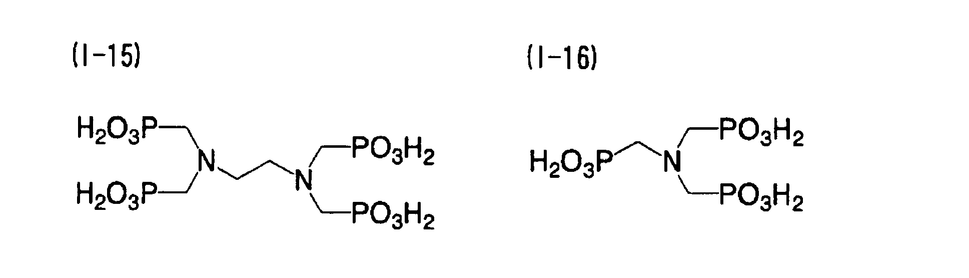

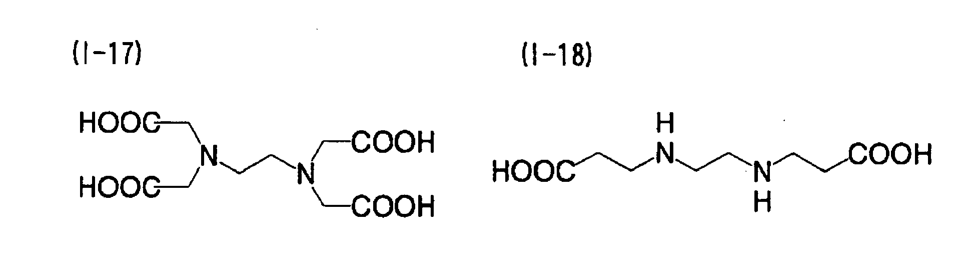

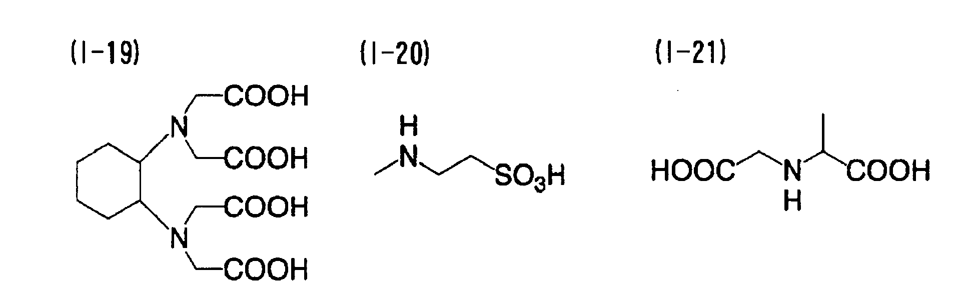

Among the above organic acids, more preferable examples include compounds I-3, I-5, I-7, I-10, and I-21. It is preferable that the polishing liquid of the invention contains a compound represented by the following formula (1) or (2) as a further preferable organic acid from a viewpoint of improvement in a polishing speed.

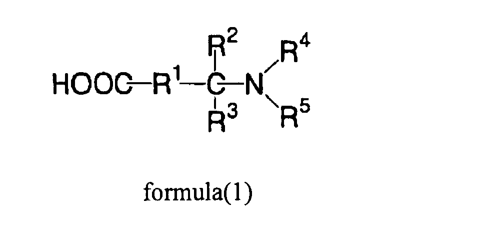

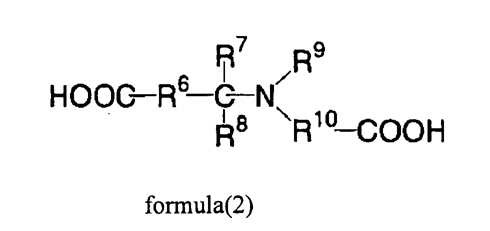

In the formula (1), R¹ represents a single bond, an alkylene group or a phenylene group. R² and R³ each independently represent a hydrogen atom, a halogen atom, a carboxyl group, an alkyl group, a cycloalkyl group, an alkenyl group, an alkynyl group, or an aryl group. R⁴ and R⁵ each represent independently a hydrogen atom, a halogen atom, a carboxyl group, an alkyl group, or an acyl group, provided that when R¹ is a single bond, at least any of R⁴ and R⁵ is not a hydrogen atom.

In the formula (2), R⁶ represents a single bond, an alkylene group, or a phenylene group. R⁷ and R⁸ each independently represent a hydrogen atom, a halogen atom, a carboxyl group, an alkyl group, a cycloalkyl group, an alkenyl group, an alkynyl group, or an aryl group. R⁹ represents a hydrogen atom, a halogen atom, a carboxyl group, or an alkyl group. R¹⁰ represents an alkylene group, provided that when R¹⁰ is -CH₂-, R⁶ is at least either of the following is satisfied; R⁶ is not a single bond, or R⁹ is not a hydrogen atom.

Specific examples of the compound represented by the formula (1) or the general formula (2) are not limited to, but include the following compounds. In the following table, "-" described in rows of R¹ and R⁶ represents a single bond.

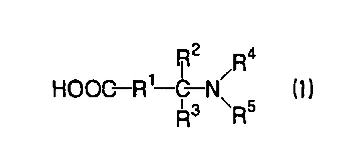

| | R¹ | R² | R³ | R⁴ | R⁵ |
|---|---|---|---|---|---|
| A-1 | - | -H | -H | -H | -CH₃ |
| A-2 | - | -H | -H | -H | -CH₂OH |
| A-3 | - | -H | -H | -CH₂OH | -CH₂OH |
| A-4 | - | -H | -H | -H | -CH₂CH₂OH |
| A-5 | - | -H | -H | -CH₂CH₂OH | -CH₂CH₂OH |
| A-6 | - | -H | -CH₃ | -H | -CH₂OH |
| A-7 | - | -H | -CH₃ | -CH₂CH₂OH | -CH₂CH₂OH |
| A-8 | - | -H | -CH₂OH | -H | -CH₂OH |
| A-9 | - | -H | -CH(CH₃)₂ | -CH₂OH | -CH₂OH |
| A-10 | - | -H | -Ph | -H | -(CH₂CH₂O)₂-H |
| A-11 | - | -H | 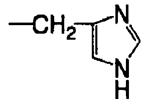 | -CH₂CH₂OH | -CH₂CH₂OH |
| A-12 | - | -H | -CH₂SCH₃ | -CH₂CH₂OH | -CH₂CH₂OH |
| A-13 | - | -H | -H | -H | -COCH₂NH₂ |
| A-14 | - | -H | -CH₂OH | -H | -COCH₂NH₂ |
| A-15 | - | -H | -H | -H | -COCH₃ |
| A-16 | -CH₂- | -H | -H | -CH₂CH₂OH | -CH₂CH₂OH |
| A-17 | -CH₂- | -H | -H | -H | -CH₂OH |
| A-18 | -CH₂- | -H | -H | -H | -COCH₂NH₂ |
| A-19 | -CH₂CH₂- | -H | -H | -H | -H |

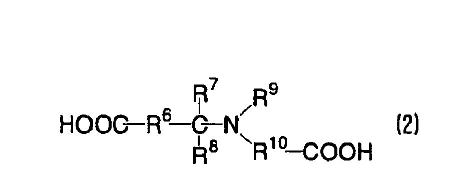

| | R⁶ | R⁷ | R⁸ | R⁹ | R¹⁰ |
|---|---|---|---|---|---|
| B-1 | - | -H | -H | -CH₃ | -CH₂- |
| B-2 | - | -H | -H | -CH₂OH | -CH₂- |
| B-3 | - | -H | -H | -CH₂ CH₂OH | -CH₂- |
| B-4 | - | -H | -H | -(CH₂ CH₂O)₁₀-H | -CH₂- |
| B-5 | - | -H | -CH₃ | -H | |
| B-6 | - | -H | -CH₂OH | -H | |
| B-7 | -CH₂- | -H | -H | -H | -CH₂- |
| B-8 | -CH₂- | -H | -H | -H | -CH₂CH₂- |
| B-9 | -CH₂- | -H | -H | -CH₂ CH₂OH | -CH₂CH₂- |
| B-10 | -CH₂- | -H | -H | -CH₂ COOH | -CH₂- |

The compound represents by the formula (1) or (2) can be synthesized by the known method, or a commercially available compound may be used. An amount of the compound represented by the formula (1) or (2) to be added is, as a total amount, preferably 0.0005 to 5 mol, more preferably 0.01 to 0.5 mol in 1 L of a metal-polishing liquid upon use in polishing.

It is preferable that both of the compound represented by the formula (1) and the compound represented by the formula (2) are used together. In this case, a ratio (compound represented by formula (1)/compound represented by general formula (2)) is, as expressed by a mass ratio, generally 100/1 to 1/100, preferably 10/1 to 1/10.

In addition, examples of a preferable organic acid other than an amino acid include organic acids selected from the following group: formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid and lactic acid. These may have a form of a salt such as an ammonium salt and an alkali metal salt.

The organic acid may be used alone, or two or more kinds may be used together in the polishing liquid of the invention. These organic acids can be synthesized according to a conventional method, or a commercially available product may be used. An amount of the organic acid to be added is preferably 0.0005 to 0.5 mol, more preferably 0.005 mol to 0.3 mol, particularly preferably 0.01 mol to 0.1 mol in 1 L of a metal-polishing liquid upon use in polishing.

### (Abrasives)

It is preferable that the metal-polishing liquid of the invention contains abrasives. Examples of preferable abrasives include silica (precipitated silica, fumed silica, colloidal silica, synthetic silica), seria, alumina, titania, zirconia, germania, manganese oxide, silicon carbide, polystyrene, polyacryl, and polyterephthalate, and it is more preferable to use colloidal silica.

An amount of abrasives to be added is preferably 0.05 to 10 g, more preferably 0.1 to 5 g in 1 L of the metal-polishing liquid upon use.

In addition, an average size (average diameter: photon scattering average particle diameter) of abrasives is preferably 50 nm or less, further preferably 30 nm or less, and preferably 5 nm or more. A variation coefficient of a diameter of abrasives is preferably 20 % or less, further preferably 10 % or less. The metal-polishing liquid of the invention may further contain other components, and examples include a surfactant, a solvent-philic polymer, and other additives. An average diameter and a variation coefficient can be measured with a particle size distribution measuring apparatus LB-500 manufactured by Horiba, Ltd.

### (Surfactant/hydrophilic polymer)

It is preferable that the polishing liquid of the invention contains a surfactant and a hydrophilic polymer. Both of a surfactant and a hydrophilic polymer have action of reducing a contact angle of a surface to be polished, and have action of promoting uniform polishing. As the surfactant and the hydrophilic polymer used, those selected from the following group are preferable.

Examples of an anionic surfactant include a carboxylic acid salt, a sulfonic acid salt, a sulfuric acid ester salt, a phosphoric acid ester salt, examples of a cationic surfactant include an aliphatic amine salt, an aliphatic quaternary ammonium salt, a benzalkonium chloride salt, benzethonium chloride, a pyridinium salt, and an imidazolinium salt, examples of an amphoteric surfactant include a carboxybetaine-type, an aminocarboxylic acid salt, imidazoliniumbetaine, lecithine, and alkylamine oxide, examples of a nonionic surfactant include an ether type, an ether ester type, an ester type, and a nitrogen-containing type, and other examples include a fluorine-based surfactant.

Further, examples of a hydrophilic polymer include polyglycols such as polyethylene glycol, polyvinyl alcohol, polyvinylpyrrolidone, polysaccharides such as alginic acid, and a carboxylic acid-containing polymer such as polymethacrylic acid.

It is desirable that the above compounds are an acid or an ammonium salt thereof since there is no pollution due to an alkali metal, an alkaline earth metal, or a halide. Among the aforementioned exemplified compounds, cyclohexanol, polyacrylic acid ammonium salt, polyvinyl alcohol, succinic acid amide, polyvinylpyrrolidone, polyethylene glycol, and polyoxyethylene polyoxypropylene block polymer are more preferable.

A weight average molecular weight of these surfactant and hydrophilic polymer is preferably 500 to 100000, particularly preferably 2000 to 50000.

An amount of the surfactant and/or hydrophilic polymer is, as a total amount, preferably 0.001 to 10 g, more preferably 0.01 to 5 g, particularly preferably 0.1 to 3 g in 1 L of a metal-polishing liquid upon use in polishing.

### (pH adjusting agent)

It is preferable that an alkali/an acid or a buffer is added to the metal-polishing liquid of the invention in order to adjust to a predetermined pH.

Preferable examples of an alkali/an acid or a buffer include organic ammonium hydroxide such as ammonium hydroxide and tetramethylammonium hydroxide, non-metal alkali agent such as alkanolamines such as diethanolamine, triethanolamine, and triisopropanolamine, alkali metal hydroxide such as sodium hydroxide, potassium hydroxide, and lithium hydroxide, inorganic acid such as nitric acid, sulfuric acid and phosphoric acid, carbonate such as sodium carbonate, phosphate such as trisodium phosphate, borate, tetraborate, and hydroxybenzoate. Examples of a particularly preferable alkali agent include ammonium hydroxide, potassium hydroxide, lithium hydroxide and teramethylammonium hydroxide.

An amount of an alkali/an acid or a buffer to be added may be such an amount that a pH is contained in a preferable range, and preferably 0.0001 mol to 1.0 mol, more preferably 0.003 mol to 0.5 mol in 1 L of a metal-polishing liquid upon use in polishing.

A pH of a metal-polishing liquid upon use in polishing is preferably 3 to 12, more preferably 4 to 9, particularly preferably 5 to 8. In this range, a metal liquid of the invention exerts the particularly excellent effect.

### (Chelating agent)

In order to reduce adverse influence of a multivalent metal ion which is mixed in, the metal-polishing liquid of the invention may contain a chelating agent, if necessary. As a chelating agent, a general-use hard water softener which is a precipitation preventing agent for calcium and magnesium, and related compounds can be used and, if necessary, two or more kinds of them may be used together. An amount of a chelating agent to be added is enough if it is a sufficient amount to sequester a metal ion such as a polyvalent metal ion which is mixed in. For example, a chelating agent is added to 0.0003 mol to 0.07 mol in 1 L of a metal-polishing liquid upon use in polishing.

### [Wiring metal raw material]

In the invention, it is preferable that a semiconductor to be polished is LSI having a wiring comprising a copper metal and/or a copper alloy, particularly a copper alloy. Among a copper alloy, a copper alloy containing silver is further preferable. A content of silver contained in a copper alloy is preferably 40 % by mass or less, particularly 10 % by mass or less, further preferably 1 % by mass or less, and the most excellent effect is exerted in a copper alloy in a range of 0.00001 to 0.1 % by mass.

### [Thickness of wiring]

In the invention, it is preferable that a semiconductor to be polished, for example, in a DRAM device system, is LSI having a wiring of 0.15µm or less, particularly 0.10µm or less, further 0.08µm or less and, on the other hand, in a MPU device system, is 0.12µm or less, particularly 0.09µm or less, further 0.07µm or less as expressed by a half pitch. The polishing liquid of the invention exerts the particularly excellent effect on these LSIs.

### [Barrier metal]

In the invention, it is preferable that a barrier layer for preventing diffusion of copper is provided between a wiring in which a semiconductor comprises a copper metal and/or a copper alloy, and an interlayer insulating film. As a barrier layer, a metal material of low resistance is proper, particularly preferably TiN, TiW, Ta, TaN, W and WN and, inter alia, Ta and TaN are particularly preferable.

### [Polishing method]

The polishing method of the invention is a method of contacting the aforementioned metal-polishing liquid of the invention with a surface to be polished, and performing polishing by relative movement of a polishing liquid and/or a polishing pad.

The metal-polishing liquid has the case where the liquid is a concentrated solution and, upon use, water is added to dilute the solution to obtain a use solution, the case where respective components are in a form of an aqueous solution described in the next item, these are mixed and, if necessary, water is added to dilute the mixture to obtain a use solution, and the case where the liquid is prepared as a use solution. The polishing method using the metal-polishing liquid of the invention can be applied to any case, and is a method of supplying a polishing liquid to a polishing pad on a polishing platen, contacting this with a surface to be polished, and polishing the surface by relative movement between a surface to be polished and a polishing pad.

As a polishing apparatus, a general polishing apparatus having a holder for holding a semiconductor substrate having a surface to be polished, and a polishing platen to which a polishing pad is applied (a motor having a variable rotation number is attached) can be used. As a polishing pad, a general non-woven fabric, expanded polyurethane and porous fluorine resin can be used without any limitation. A polishing condition is not limited, and a rotation rate of a polishing platen is preferably 3000 rpm or less so that a substrate is not flown out.

In order to reduce a defect such as a scratch, it is preferable to perform polishing at a low polishing pressure of around 1 psi or less, but it becomes difficult to maintain in-plane uniformity. It is thought that as a polishing pressure is reduced, a passive film removing rate is reduced, and it is preferable to reduce a passive film forming rate in conformity with it.

During polishing, a metal-polishing liquid is continuously supplied to a polishing pad with a pump. This supply amount is not limited, but it is preferable that a surface of a polishing pad is usually covered with a polishing liquid. A semiconductor substrate after completion of polishing is washed well in running water, and is dried after water droplets attached to a semiconductor substrate have been removed using a spin dryer. In the polishing method of the invention, an aqueous solution used in dilution is the same as an aqueous solution described next. An aqueous solution is water containing at least one of an oxidizing agent, an acid, an additive, and a surfactant in advance, and components contained in an aqueous solution and components of a total of components of a metal-polishing liquid to be diluted are made to be components upon polishing using a metal-polishing liquid. When the liquid is used by diluting with an aqueous solution, a hardly-soluble component can be blended in a form of an aqueous solution, and a more concentrated metal-polishing liquid can be prepared.

As a method of diluting a concentrated metal-polishing liquid by adding water or an aqueous solution thereto, there is a method of mixing a concentrated metal-polishing liquid and water or an aqueous solution by joining midway a piping for supplying the liquid and a piping for supplying water or an aqueous solution, and supplying a mixed and diluted metal-polishing liquid to a polishing pad. For mixing, a method which is usually performed such as a method of passing through a narrow path under the pressure state to collide and mix liquids, a method of charging a filler such as a glass tube in a piping, and repeating separating and joining of streams of liquids, and a method of providing a wing which is rotated with a motive power in a piping can be adopted.

A rate of supplying a metal-polishing liquid to a wafer polishing surface is preferably 10 to 1000 ml/min and, in order to satisfy planarity of a pattern, more preferably 100 to 500 ml/min.

As a method of diluting a concentrated metal-polishing liquid with water or an aqueous solution and performing polishing, there is a method of independently providing a piping for supplying a metal-polishing liquid and a piping for supplying water or an aqueous solution, supplying a predetermined amount of a liquid to a polishing pad from each piping, and performing polishing while liquids are mixed by relative movement between a polishing pad and a surface to be polished. Alternatively, there is a method of placing a predetermined amount of a concentrated metal-polishing liquid and water or an aqueous solution into one container, and mixing them, supplying a mixed metal-polishing liquid to a polishing pad, and performing polishing.

Another polishing method of the invention is a method of dividing components to be contained in a metal-polishing liquid into at least two constitutional components and, upon use of them, adding water or an aqueous solution to dilute components, supplying this to a polishing pad on a polishing platen, and performing polishing by relative movement between a surface to be polished and a polishing pad while the polishing pad is contacted with a surface to be polished.

For example, an oxidizing agent as one constitutional component (A), and an acid, an additive, a surfactant and water as constitutional component (B) and, upon use thereof, the constitutional component (A) and the constitutional component (B) are diluted with water or an aqueous solution and used.

Alternatively, additives having low solubility are divided into two constitutional components (A) and (B) and, letting an oxidizing agent, an additive and a surfactant to be one constitutional component (A), and letting an acid, an additive, a surfactant and water to be one constitutional component (B) and, upon use of them, water or an aqueous solution is added to dilute the constitutional component (A) and the constitutional component (B), which is used. In this case, three pipings for supplying the constitutional component (A), the constitutional component (B) and water or an aqueous solution, respectively, are necessary and, as dilution and mixing, there is a method of connecting three pipings to one piping for supplying a polishing pad, and mixing them in that piping. In this case, after two pipings are connected, other one piping may be connected.

For example, this is a method of mixing a constitutional component containing a hardly-soluble additive and other constitutional component, and extending a mixing passway to maintain a dissolution time, thereafter, connecting a piping for water or an aqueous solution. Other mixing method is a method of directly introducing three pipings to a polishing pad, respectively, and mixing components by relative movement between a polishing pad and a surface to be polished as described above, or a method of mixing three constitutional components into one container, and supplying a diluted metal-polishing liquid therefrom. In the aforementioned polishing method, it is also possible that, a temperature of one constitutional component containing an oxidizing agent is set to be 40°C or lower, other constitutional component is warmed to a range from room temperature to 100°C, one constitutional component, and other constitutional component or water or an aqueous solution are added to dilute them and, upon use, a temperature may be set to be 40°C or lower after mixing. Since a temperature is high, solubility is increased and, therefore, this is a preferable method for increasing solubility of a raw material having low solubility of a metal-polishing liquid.

Since a raw material obtained by warming other component containing no oxidizing agent in a range of room temperature to 100°C to dissolve the component is precipitated in a solution when a temperature is lowered in temperature, when the component, which has been lowered is used, it is necessary to warm it in advance to dissolve precipitates.

For this, a means to flow a constitutional component liquid obtained by warming to dissolve it, and a means to stir a liquid containing precipitates, flow this, and warm a piping to dissolve it can be adopted. Since when a temperature of one constitutional component in which a warmed component contains an oxidizing agent is elevated to 40°C or higher, an oxidizing agent may be degraded, in the case where a warmed constitutional component, and one constitutional component containing an oxidizing agent for cooling this warmed constitutional component are mixed, a temperature is set to be 40°C or lower.

In addition, in the invention, as described above, components of a metal-polishing liquid are divided into two or more, and they may be supplied to a polishing surface. In this case, it is preferable to divide components into a component containing oxide and a component containing an acid, and supply them. Alternatively, a metal-polishing liquid is converted into a concentrate, and diluting water may be supplied to a polishing surface separately.

### [Pad]

A pad for polishing may be a non-form structure pad or a foam structure pad. In the former, a hard synthetic resin bulk material such as a plastic plate is used in a pad. In addition, in the latter, there are further three types of of a closed-cell foam (wet foam), an open-cell foam (wet foam), and a bilayered complex (laminate) and, particularly, a bilayered complex (laminate) is preferable. Expansion may be uniform or ununiform.

Further, abrasives (e.g. seria, silica, alumina, resin etc.) used in polishing may be contained. In addition, abrasives have a hardness of soft and hard, any of them may be used and, in a lamination system, it is preferable to use abrasives having different hardnesses in each layer. As a material, a non-woven fabric, an artificial leather, polyamide, polyurethane, polyester, and polycarbonate are preferable. In addition, a surface contacting with a polishing surface may be subjected to processes such as foaming lattice grooves/hole/ concentric grooves/spiral grooves.

### [Wafer]

A subject wafer on which CMP is performed with the metal-polishing liquid of the invention has a diameter of preferably 200 mm or more, particularly preferably 300 mm or more. When a diameter is 300 mm or more, the effect of the invention is remarkably exerted.

### Examples

The present invention will be explained below by way of Examples, but the invention is not limited by these Examples.

### <Examples 1 to 3 and Comparative Examples 1 and 2>

The following materials were mixed, pure water was added to a total amount of 1000 mL, so that the materials had the following concentrations, thereby, a polishing liquid was prepared, and the liquid was assessed by performing a polishing test.

### (Material)

Colloidal silica (average diameter 30 nm, particle variation coefficient 20 %)···amount shown in the following Table 1
Heterocyclic aromatic ring compound or benzotriazole (BTA)···0.001 M
Hydrogen peroxide (oxidizing agent)··· 15 g/L
A-5 which is a specific compound of the general formula (1), or glycine···0.08 M
Dodecylbenzenesulfonic acid (DBS)···amount shown in Table 1
pH···6.8

### (Polishing test)

Substrate: Silicon substrate on which copper/silver alloy film having thickness of 1 µm is formed
Polishing pad: IC1400K-Groove (Rodel Corp.)
Polishing machine: LGP-612 (LapmaSter SFT Corp.)
Polishing pressure: 240g/cm²
Polishing liquid supplying rate: 170 ml/min
Wafer diameter: 200 mm
Wafer: Cu blanket wafer, or CMP854 pattern wafer (diameter 200 mm) manufactured by Sematech
Polishing pad/wafer rotation number: 95/95 rpm

### (Evaluation method)

### [In-plane uniformity of polishing amount]

Regarding forty nine places on a wafer, a difference in a film thickness before and after CMP of a metal film was converted from an electric resistance value to obtain an average polishing rate, and in-plane uniformity was obtained from an in-plane scatter in a polishing amount. Results are shown in the following Table 1.

### [Scratch]

Using a wafer surface defect test device SP-1 manufactured by KLA-Tencor Corp., the number of defects of 0.5µm or greater on a wafer surface after polishing was measured. Results are shown in the following Table 1.

### [the time until the oxidation reaction rate is (E1+E2)/2]

An initial oxidation rate E1 and an oxidation reaction rate E2 in the steady state by measurement of an erosion current were measured by the following method. As an electrochemical measuring instrument, Model 263A manufactured by Princeton Applied Research (PAR) Corp.was used, as a reference electrode, a silver-silver chloride electrode was used, as a working electrode, a copper plate having a purity of 99.99 % or more was used and, as a counter electrode, a platinum electrode was used. A polishing liquid with an oxidizing agent added thereto, and a polishing liquid from which an oxidizing agent had been removed were prepared, an open potential (corrosion potential) when each liquid was used was obtained with the above measuring instrument, and a difference in the potential was adopted as an oxidation potential of an oxidizing agent. Using a polishing liquid with no oxidizing agent added, a voltage corresponding to an oxidation potential was applied to the open circuit state, and a change in a corrosion current density (A/cm²) with time was traced at a sampling time of 100 millisecond. A corrosion current density (A/cm²) was converted into an oxidation reaction rate (nm/min) using a Faraday constant, a copper molecular weight, and a metal copper density.

The time until the reaction rate is E1 and E2 respectively thus measured were obtained with the aforementioned measuring instrument, and (E1+E2)/2 was calculated to obtain the time until the oxidation reaction rate is (E1+E2)/2. Results are shown in the following Table 1.

### [Adsorption selectivity]

Adsorbability of a heterocyclic aromatic ring compound onto metal copper and copper oxide was measured by the following method. A surface area of a metal copper particle and a copper oxide particle having a particle diameter of about a few millimeters was measured by a BET method, a surface of a metal copper particle and a copper oxide particle at an amount corresponding to a surface area of 0.005 m² was washed with 0.1 N sulfuric acid, and the particle was dispersed in 100 ml of water. One ml of a 7.5×10-6 M aqueous heterocyclic aromatic ring compound solution was added to this dispersion, and this was stirred at 40°C for 30 minutes. Thereafter, a heterocyclic aromatic ring concentration of a supernatant was quantitated with ICP, and a reciprocal of an adsorption amount was calculated. Adsorption selectivity of a heterocyclic aromatic ring compound on copper oxide/metal copper was expressed by the aforementioned adsorption amount ratio. Results are shown in the following Table 1.

Heterocyclic aromatic ring compounds "H-1" to "H-3" in the following Table 1 are the following compounds, and LogP values of them and a LogP value of BTA are as follows. Heterocyclic aromatic ring compounds other than "H-1" to "H-3" are the above-exemplified compounds. 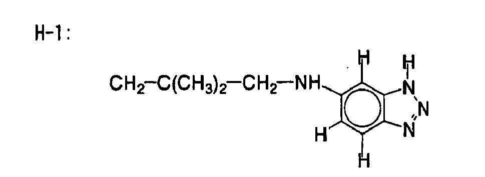 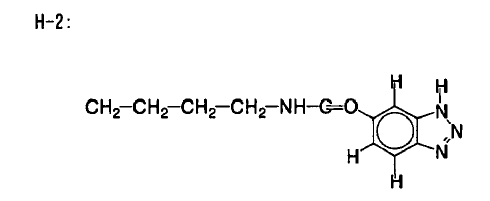 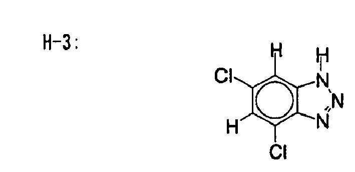
LogP value of H-1: 3.70
LogP value of H-2: 2.17
LogP value of H-3: 2.83
LogP value of BTA (benzotriazole): 1.41

**Table 1**

| | Composition | | | | | | | Assessment | |
|---|---|---|---|---|---|---|---|---|---|
| Example No. | Compound of formula (1) or (2), or glycine (0.08 M) | Heterocyclic aromatic ring compound (0.001M) | Abrasive concentration (mass%) | DBS (mass%) | Kind of wafer | Necessary time for (E1+E2)/2 (sec) | Copper oxide/metal copper adsorption selectivity | In-plane uniformity (%) | Scratch (number/Wf) |
| Example 1 | glycine | H-1 | 0.6 | 0.4 | Cu blanket wafer | 0.2 | 0.61 | 4.5 | 451 |
| Example 2 | glycine | H-2 | 0.6 | 0 | Cu blanket wafer | 0.3 | 0.35 | 4.8 | 953 |
| Example 3 | glycine | H-3 | 0.6 | 0.4 | Cu blanket wafer | 0.3 | 0.45 | 5.0 | 648 |
| Comparati ve Example 1 | A-5 | BTA | 0.6 | 0.4 | Cu blanket wafer | 1.0 | 1.05 | 9.5 | 7251 |
| Comparati ve Example 2 | glycine | BTA | 1.2 | 0 | Cu blanket wafer | 1.1 | 1.30 | 12.9 | 9016 |

From results of the Table 1, it is seen that in the metal-polishing liquid of the invention (metal-polishing liquids of Examples 1 to 3), in-plane uniformity is better, and a scratch is small.

According to the invention, a metal-polishing liquid satisfying both of better in-plane uniformity and low scratch, and a chemical mechanical polishing method can be provided.

The invention also includes the following embodiments.
<1> A metal-polishing liquid comprising an oxidizing agent and a heterocyclic aromatic ring compound, wherein the time until the oxidation reaction rate is (E1+E2)/2 is shorter than 1.0 second, E1 being an oxidation reaction rate immediately after initiation of oxidation of a metal surface to be polished and E2 being an oxidation reaction rate when the oxidation reaction has reached a steady state.
<2> The metal-polishing liquid according to <1>, wherein an oxidizing agent and a heterocyclic aromatic ring compound, the heterocyclic aromatic ring compound being a compound having higher adsorbability to copper metal than adsorbability to copper oxide.
<3> The metal-polishing liquid according to <1> and <2>, comprising a heterocyclic aromatic ring compound represented by the following formula (A), and 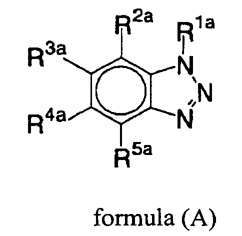 wherein in formula (A), R^{1a} to R^{5a} each independently represent a substituent, provided that R^{2a} to R^{5a} are a substituent other than a methyl group, and adjacent two substituents of R^{1a} to R^{5a} may be linked together to form a ring.
<4> The metal-polishing liquid according to any one of through <1> to <3>, which contains abrasives in a range of 2 % by mass or less.
<5> The metal-polishing liquid according to any one of through <1> to <4>, wherein an average diameter of the abrasives is 50 nm or less, and a coefficient of variation of a diameter of the abrasives is 20 % or less.
<6> The polishing liquid according to any one of through <1> to <5>, which contains a compound represented by the following formula (1) or (2), 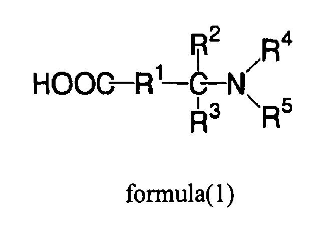 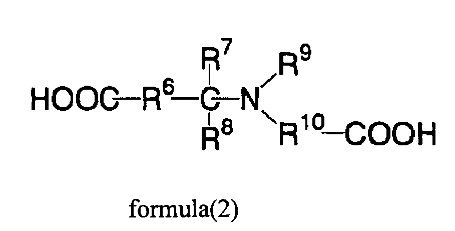 wherein in formula (1): R¹ represents a single bond, an alkylene group, or a phenylene group; R² and R³ each independently represent a hydrogen atom, a halogen atom, a carboxyl group, an alkyl group, a cycloalkyl group, an alkenyl group, an alkynyl group, or an aryl group; R⁴ or R⁵ each independently represent a hydrogen atom, a halogen atom, a carboxyl group, an alkyl group or an acyl group; provided that when R¹ is a single bond, at least any one of R⁴ or R⁵ is not a hydrogen atom; in the general formula (2); R⁶ represents a single bond, an alkylene group, or a phenylene group; R⁷ and R⁸ each represent independently a hydrogen atom, a halogen atom, a carboxyl group, an alkyl group, a cycloalkyl group, an alkenyl group, an alkynyl group, or an aryl group; R⁹ represents a hydrogen atom, a halogen atom, a carboxyl group or an alkyl group; R¹⁰ represents an alkylene group, provided that when R¹⁰ is -CH₂-, R⁶ is not a single bond and/or R⁹ is not a hydrogen atom.
<7> The metal-polishing liquid according to any one of through <1> to <6>, which further comprises a surfactant.
<8> A chemical-mechanical polishing method comprising contacting with the surface to be polished metal-polishing liquid of any one of through <1> to <7>, and performing polishing by relative movement between the surface to be polished and the polishing-liquid and/or a polishing pad.

All publications, patent applications, and technical standards mentioned in this specification are herein incorporated by reference to the same extent as if such individual publication, patent application, or technical standard was specifically and individually indicated to be incorporated by reference.

It will be obvious to those having skill in the art that many changes may be made in the above-described details of the preferred embodiments of the present invention. The scope of the invention, therefore, should be determined by the following claims.

## Claims

1. A metal-polishing liquid comprising an oxidizing agent and a heterocyclic aromatic ring compound,
wherein the time until the oxidation reaction rate is (E1+E2)/2 is shorter than 1.0 second, E1 being an oxidation reaction rate immediately after initiation of oxidation of a metal surface to be polished and E2 being an oxidation reaction rate when the oxidation reaction has reached a steady state.

2. The metal-polishing liquid according to claim 1, which contains abrasives in a range of 2 % by mass or less.

3. The metal-polishing liquid according to claim 1, wherein an average diameter of the abrasives is 50 nm or less, and a coefficient of variation of a diameter of the abrasives is 20 % or less.

4. The polishing liquid according to claim 1, which contains a compound represented by the following formula (1) or (2), 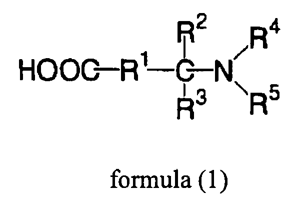 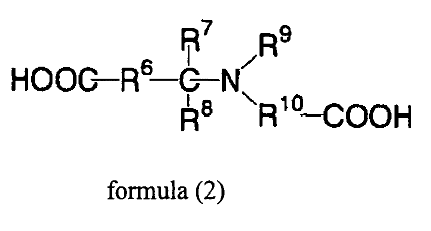 wherein in formula (1): R¹ represents a single bond, an alkylene group, or a phenylene group; R² and R³ each independently represent a hydrogen atom, a halogen atom, a carboxyl group, an alkyl group, a cycloalkyl group, an alkenyl group, an alkynyl group, or an aryl group; R⁴ or R⁵ each independently represent a hydrogen atom, a halogen atom, a carboxyl group, an alkyl group or an acyl group; provided that when R¹ is a single bond, at least any one of R⁴ or R⁵ is not a hydrogen atom; and in the formula (2): R⁶ represents a single bond, an alkylene group, or a phenylene group; R⁷ and R⁸ each independently represent a hydrogen atom, a halogen atom, a carboxyl group, an alkyl group, a cycloalkyl group, an alkenyl group, an alkynyl group, or an aryl group; R⁹ represents a hydrogen atom, a halogen atom, a carboxyl group or an alkyl group; R¹⁰ represents an alkylene group, provided that when R¹⁰ is -CH₂-, R⁶ is not a single bond and/or R⁹ is not a hydrogen atom.

5. The metal-polishing liquid according to claim 1, which further comprises a surfactant.

6. A metal-polishing liquid comprising an oxidizing agent and a heterocyclic aromatic ring compound,
the heterocyclic aromatic ring compound being a compound having higher adsorbability to copper metal than adsorbability to copper oxide,
wherein the time until the oxidation reaction rate is (E1+E2)/2 is shorter than 1.0 second, E1 being an oxidation reaction rate immediately after initiation of oxidation of a metal surface to be polished and E2 being an oxidation reaction rate when the oxidation reaction has reached a steady state.

7. A metal-polishing liquid comprising an oxidizing agent and a heterocyclic aromatic ring compound,
the heterocyclic aromatic ring compound being a compound represented by the following formula (A),
wherein the time until the oxidation reaction rate is (E1+E2)/2 is shorter than 1.0 second, E1 being an oxidation reaction rate immediately after initiation of oxidation of a metal surface to be polished and E2 being an oxidation reaction rate when the oxidation reaction has reached a steady state. 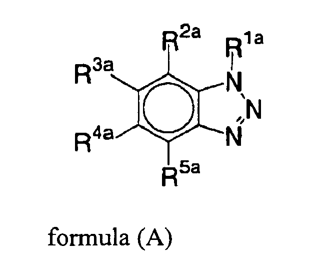 wherein in formula (A), R^{1a} to R^{5a} each independently represent a substituent, provided that R^{2a} to R^{5a} are a substituent other than a methyl group, and adjacent two substituents of R^{1a} to R^{5a} may be linked together to form a ring.

8. The metal-polishing liquid according to claim 7, which contains abrasives in a range of 2 % by mass or less.

9. The metal-polishing liquid according to claim 7, wherein an average diameter of the abrasives is 50 nm or less, and a coefficient of variation of the diameter of the abrasives is 20 % or less.

10. The metal-polishing liquid according to claim 7, which further comprises a compound represented by the following formula (1) or (2), 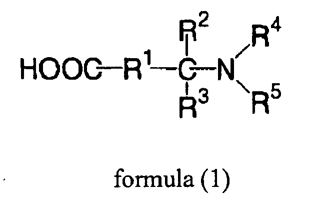 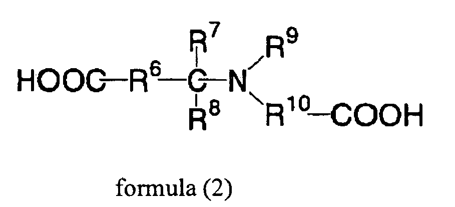 wherein in formula (1): R¹ represents a single bond, an alkylene group or a phenylene group; R² and R³ each independently represent a hydrogen atom, a halogen atom, a carboxyl group, an alkyl group, a cycloalkyl group, an alkenyl group, an alkynyl group, or an aryl group; R⁴ and R⁵ each independently represent a hydrogen atom, a halogen atom, a carboxyl group, an alkyl group or an acyl group; provided that when R¹ is a single bond, at least any one of R⁴ or R⁵ is not a hydrogen atom; and in formula (2): R⁶ represents a single bond, an alkylene group or a phenylene group; R⁷ and R⁸ each independently represent a hydrogen atom, a halogen atom, a carboxyl group, an alkyl group, a cycloalkyl group, an alkenyl group, an alkynyl group or an aryl group; R⁹ represents a hydrogen atom, a halogen atom, a carboxyl group or an alkyl group; R¹⁰ represents an alkylene group; provided that when R¹⁰ is -CH₂-, R⁶ is not a single bond and/or R⁹ is not a hydrogen atom.

11. The metal-polishing liquid according to claim 7, which further comprises a surfactant.

12. The metal-polishing liquid according to claim 8, wherein an average diameter of the abrasives is 50 nm or less, and a coefficient of variation of a diameter of abrasives is 20 % or less.

13. The polishing liquid according to claim 12, which contains a compound represented by the following general formula (1) or (2), 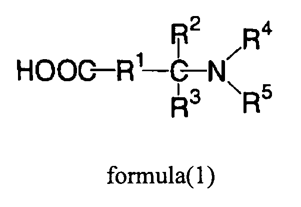 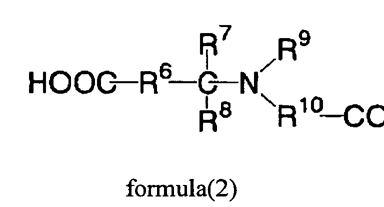 wherein in the formula (1); R¹ represents a single bond, an alkylene group or a phenylene group; R² and R³ each independently represent a hydrogen atom, a halogen atom, a carboxyl group, an alkyl group, a cycloalkyl group, an alkenyl group, an alkynyl group, or an aryl group; R⁴ and R⁵ each independently represent a hydrogen atom, a halogen atom, a carboxyl group, an alkyl group or an acyl group; provided that when R¹ is a single bond, at least any one of R⁴ or R⁵ is not a hydrogen atom; and in the formula (2): R⁶ represents a single bond, an alkylene group or a phenylene group; R⁷ and R⁸ each independently represent a hydrogen atom, a halogen atom, a carboxyl group, an alkyl group, a cycloalkyl group, an alkenyl group, an alkynyl group or an aryl group; R⁹ represents a hydrogen atom, a halogen atom, a carboxyl group or an alkyl group; R¹⁰ represents an alkylene group; provided that when R¹⁰ is -CH₂-, R⁶ is not a single bond and/or R⁹ is not a hydrogen atom.

14. The metal-polishing liquid according to claim 13, which further comprises a surfactant.

15. A chemical-mechanical polishing method comprising contacting with the surface to be polished metal-polishing liquid of claim 1, and performing polishing by relative movement between the surface to be polished and the polishing-liquid and/or a polishing pad.

16. A chemical-mechanical polishing method comprising contacting with the surface to be polished metal-polishing liquid of claim 6, and performing polishing by relative movement between the surface to be polished and the polishing-liquid and/or a polishing pad.

17. A chemical-mechanical polishing method comprising contacting with the surface to be polished metal-polishing liquid of claim 7, and performing polishing by relative movement between the surface to be polished and the polishing-liquid and/or a polishing pad.

18. A chemical-mechanical polishing method comprising contacting with the surface to be polished metal-polishing liquid of claim 12, and performing polishing by relative movement between the surface to be polished and the polishing-liquid and/or a polishing pad.

19. A chemical-mechanical polishing method comprising contacting with the surface to be polished metal-polishing liquid of claim 13, and performing polishing by relative movement between the surface to be polished and the polishing-liquid and/or a polishing pad.

20. A chemical-mechanical polishing method comprising contacting with the surface to be polished metal-polishing liquid of claim 14, and performing polishing by relative movement between the surface to be polished and the polishing-liquid and/or a polishing pad.
